# EUROPEAN PATENT SPECIFICATION

(11) **EP 2 580 375 B1**
(45) Date of publication and mention of the grant of the patent: **28.09.2016**
(21) Application number: 11725914.3
(22) Date of filing: 09.06.2011
(51) Int. Cl.: C25D 3/38, C25D 7/12, H01L 21/288, H01L 21/768

(54) **COPPER-ELECTROPLATING COMPOSITION AND PROCESS FOR FILLING A CAVITY IN A SEMICONDUCTOR SUBSTRATE USING THIS COMPOSITION**
KUPFERGALVANISIERUNGSZUSAMMENSETZUNG UND VERFAHREN ZUM FÜLLEN EINES HOHLRAUMS IN EINEM HALBLEITERSUBSTRAT MITHILFE DIESER ZUSAMMENSETZUNG
COMPOSITION POUR LE DÉPÔT ÉLECTROLYTIQUE DE CUIVRE, ET PROCÉDÉ DE REMPLISSAGE D'UNE CAVITÉ DANS UN SUBSTRAT SEMI-CONDUCTEUR UTILISANT LADITE COMPOSITION

(30) Priority: 25.02.2011 FR 1151583; 11.06.2010 FR 1054668
(43) Date of publication of application: 17.04.2013
(73) Proprietor: aveni, 91300 Massy (FR)
(72) Inventor: FREDERICH, Nadia, F-13530 Trets (FR); RAYNAL, Frédéric, F-75012 Paris (FR); GONZALEZ, José, F-75019 Paris (FR)
(74) Representative: Hubert, Philippe
(86) International application number: PCT/EP2011/059581
(87) International publication number: WO 2011/154493

(56) References cited:
- WO-A2-2010/001054
- JP-A- 2006 265 632
- US-A1- 2003 070 934
- US-B2- 7 579 274
- DATABASE WPI Week 198141 Thomson Scientific, London, GB; AN 1981-75114D XP002616099, GERASIMOV V V; LOSHKAREV M A; POPOVICH V A: "Electrolyte for bright copper plating - contains copper sulphate, potassium pyrophosphate, thio-di:glycolic acid and beta-thio-di:glycol", & SU 796 249 A1 ((LOSH-I) LOSHKAREV M A) 15 January 1981 (1981-01-15)
- LEFEBVRE, M.; NAJJAR, E.; GOMEZ, L.; BARSTAD, L.; CHEN, B.; BAYES, M.;: "Electroplating equipment design considerations for copper microvia filling", MICROSYSTEMS, PACKAGING, ASSEMBLY AND CIRCUITS TECHNOLOGY CONFERENCE, 2009. IMPACT 2009. 4TH INTERNATIONAL, 2009, pages 77-80, XP002616100,
- BIOH KIM ET AL: "Factors Affecting Copper Filling Process Within High Aspect Ratio Deep Vias for 3D Chip Stacking", ELECTRONIC COMPONENTS AND TECHNOLOGY CONFERENCE 2006, 56TH SAN DIEGO, CA MAY 30 - JUNE 2, 2006, PISCATAWAY, NJ, USA,IEEE, 30 May 2006 (2006-05-30), pages 838-843, XP010923484, DOI: DOI:10.1109/ECTC.2006.1645755 ISBN: 978-1-4244-0152-9

## Description

The present invention generally relates to an electroplating composition intended for filling a cavity in a semiconductor substrate, such as a "through-via" structure, with copper.

The main application of the invention is to the microelectronics field for the metallization of through-vias (also called through silicon vias, through-wafer vias or through-wafer interconnects), a keystone technology for the three-dimensional or vertical integration of electronic chips or dies. The invention may also be applied to other electronics fields where through-vias or cavities in a substrate must be filled with copper. Mention is made in this context of the fabrication of interconnecting elements in printed circuits (also called printed circuit boards or printed wire boards) or the fabrication of passive elements, such as inductors, or electromechanical elements in integrated circuits or microsystems (microelectromechanical systems or MEMS).

Current electronic systems are composed, for the most part, of several integrated circuits, or components, and each integrated circuit has one or more functions. For example, a computer comprises at least one microprocessor and several memory circuits. Each integrated circuit usually corresponds to an individually packaged electronic chip. The integrated circuits are soldered to or slotted into, for example, a printed circuit board (PCB) which ensures the interconnection of the integrated circuits.

In the last several generations of integrated circuits, the unrelenting need to increase functional density has led to systems being designed according to the "system on chip" concept. All the components and circuit blocks required to carry out all the functions of the system are then produced on the same chip, without the use of a printed circuit board. In practice it is nevertheless very difficult to fabricate a high-performance "system on chip" because the processes for fabricating logic and memory circuits, for example, differ greatly.

The "system on chip" approach has therefore required compromises to be made regarding the performance of the various functions carried out by the same chip. In addition, the size of such chips and their fabrication yield are reaching the limits of their economic feasibility.

Another approach consists in fabricating, in a given package, a module ensuring the interconnection of several integrated circuits, which can then be derived from the same semiconductor substrate or from different substrates. The package or "multi-chip module" (MCM) thus obtained therefore takes the form of a single component. There are various MCM substrate technologies e.g. laminate or ceramic technologies. For all of them the MCM approach allows a higher interconnection density to be obtained and therefore better performance than a conventional PCB approach. Nevertheless, it is not fundamentally different therefrom. Apart from the bulk and the weight of the package, the performance of an MCM remains limited by parasitic elements associated with the length of the connections from the substrate and with the wires connecting the substrate or the chips to the pins of the package.

With a three-dimensional (3D) or vertical integration, chips are stacked and connected together by vertical interconnects. The stack obtained comprises several layers or strata of active components or chips; it forms a three-dimensional integrated circuit (3D IC).

The advantages of 3D integration stem simultaneously:
(1) from the improved performance, e.g. the reduction in propagation time and in dissipated power, the increased operating speed of the system associated with faster communication between the functional blocks, the increased bandwidth of each functional block, and the greater immunity to noise;
(2) from the reduced cost, e.g. increased integration density, better fabrication yield (thanks to the use of the generation of electronic chip most appropriate to each functional block), and improved reliability; and
(3) from the possibility of producing highly integrated systems by the stacking of heterogeneous technologies (also called co-integration), i.e. involving various materials and/or various functional components.

At the present time 3D integration is an indispensable alternative to conventional approaches, which are reaching their limits in terms of performance, functional diversification and production cost. After the chips have been stacked, for example by bonding, they can be individually connected to the pins of the package using connecting wires. Nevertheless high-density interconnection of the chips can be obtained only by employing through-vias. The basic principles and advantages of 3D integration have been described for example by A.W. Topol, D.C. La Tulipe, L. Shi, D.J. Frank, K. Bernstein, S.E. Steen, A. Kumar, G.U. Singco, A.M. Young, K.W. Guarini and M. Leong in "Three-dimensional integrated circuits", IBM Journal Res. & Dev., Vol. 50, No. 4/5, July/September 2006, pages 491-506.

Silicon wafer thinning, alignment between layers, bonding of the layers and etching and metallization of the through-vias within each layer are elementary technologies required to produce three-dimensional integrated circuits.

Three-dimensional circuits can be produced by thinning the silicon wafer before the fabrication of the through-vias (e.g. US patents Nos 7 060 624 and 7 148 565).

The vias can also be etched and metallized before thinning of the silicon wafer (e.g. US patents Nos 7 060 624 and 7 101 792). In this case, the vias are etched in the silicon then metallized to the required depth before the silicon wafer is thinned. The vias are therefore blind vias during their metallization.

The good electrical conductivity of copper and its high resistance to electromigration, i.e. the small amount of migration of copper atoms under the effect of the electric current density, which can be an important cause of failure, make copper in particular a material of choice for metallizing through-vias.

Through-vias are generally produced in a manner similar to the "damascene" process (used in the microelectronics field for the fabrication of interconnects in integrated circuits), in a succession of steps comprising:
- etching of the vias in or through the silicon wafer;
- deposition of an insulating dielectric layer (generally silicon oxide or silicon nitride, for example);
- deposition of a barrier layer or liner (generally tantalum (Ta), titanium (Ti), tantalum nitride (TaN), titanium nitride (TiN), titanium tungsten (TiW) and tungsten-carbon-nitride (WCN) or combinations of these materials for example), serving to prevent migration of the copper;
- deposition of a thin film of copper, called a seed layer;
- filling of the vias by copper electroplating; and
- removal of the excess copper by chemical-mechanical polishing.

The vias thus formed are characterized by their aspect ratio, which defines the ratio between the depth and the diameter of the via. A 10:1 aspect ratio defines a via having a diameter that is ten times smaller than its depth.

The steps of depositing the barrier layer and the seed layer and the filling and polishing of the copper are conventionally referred to together by the expression "metallization of the through-vias".

The barrier layer generally has too high a resistance to allow, by direct electrochemical processing, homogeneous or uniform copper deposition at the wafer scale, an effect known to those skilled in the art as ohmic drop. The high resistance of the barrier layer results from the high resistivity of the materials that form it (metal nitrides for example).

Thus it is necessary, before the copper electroplating filling step, to cover the barrier layer with a thin layer of copper, called a seed layer.

The barrier layer and the seed layer are generally deposited using physical or chemical vapor deposition (PVD for physical vapor deposition and CVD for chemical vapor deposition).

Physical vapor deposition (PVD) is currently preferred from the industrial standpoint because it allows surfaces having a high resistivity to be coated with a substantially better adhesion of copper to the barrier than that obtained with CVD processes.

The thickness of the coating deposited by PVD is directly proportional to the solid angle seen from the surface to be coated. Therefore, those parts of the surface having positive angles are covered with a thicker layer than those parts of the surface having reentrant angles. As a result, the copper seed layers formed by physical vapor deposition are not conformal and therefore do not have a uniform thickness at all points on the surface of the substrate.

In particular, high-density three-dimensional integrated circuits require the use of anisotropic silicon etching processes to obtain vias with vertical profiles. The anisotropic etching of silicon (e.g. US patent No 5 501 893) usually results in a bowed, rough and striated or scalloped profile. Thus, the sidewalls of the vias may not in parts be covered, or covered with an insufficient thickness of the barrier layer and seed layer.

At the present time, conventional copper electroplating is mainly used to fill through-vias, and comprises applying a current to a wafer covered beforehand with a seed layer and submersed in a copper sulfate acid bath containing "accelerator" and "suppressor" type additives (e.g. US 7 060 624 and WO 2009/018581).

This copper sulfate acid bath is very chemically aggressive with respect to the seed layers, causing them to partially dissolve in the first moments of the electroplating. This dissolution of the seed layer is critical when its thickness is very small (even almost zero), which is in particular the case on the sidewalls of the vias. This is because a rupture of the seed layer at the start of electroplating causes an electrical nonuniformity, and consequently the subsequent filling of the vias is imperfect resulting in voids.

The barrier layer beneath the seed layer may also be attacked by a copper sulfate acid bath, causing reliability problems related to the diffusion of the copper into the isolation.

In this context, there is a real need to provide a technical solution allowing vias to be filled by the electroplating of copper by means of a chemical solution that is less aggressive with respect to the seed layers and the barrier layers.

A method of filling dual-damascene interconnect structures by means of pH-neutral or slightly acidic electroplating solutions (that are therefore very unaggressive with respect to the seed layers) is known, especially from patent US 7 579 274. This technical solution is described for structures having dimensions very different to those of through-vias, and the aspect ratios of which are no greater than 3:1. It has been observed that this solution cannot be used for "through-via" type structures in three-dimensional integrated circuits, the aspect ratios of which may reach 20:1 and higher.

The acidic electroplating compositions generally used at the industrial scale to fill "through-vias" in the production of three-dimensional integrated circuits generate a certain number of contaminants, especially carbon, chlorine and sulfur.

When present in the circuits of microelectronic devices, these contaminants can cause reliability problems and current leakage because they are able to move through the material under the effect of electric fields.

There is therefore a real need to provide electroplating compositions which, when used to fill through-vias, minimize the amount of contaminants generated.

The objective of the present invention is therefore to solve the problem of filling "through-via" type structures with copper, especially for the production of three-dimensional integrated circuits, by means of solutions that are chemically unaggressive with respect to the seed layers and barrier layers, and that do not generate contaminants, in particular carbon, chlorine and sulfur in large amounts.

It has been found, and this forms the basis of the present invention, that it is possible to solve the aforementioned technical problem using very specific electroplating compositions, which are based on a mixture of copper, ethylenediamine, ammonium sulfate and thiodiglycolic acid.

The compositions according to the invention are very unaggressive with respect to the seed layers and the barrier layers and do not generate contaminants, in particular carbon, chlorine and sulfur, in large amounts.

The expression "unaggressive" solution is understood to mean a chemical composition that does not consume the seed and/or barrier layers, i.e. their thickness is not reduced over time by dissolution in said chemical composition.

Thus, according to a first aspect, one subject of the present invention is a composition especially intended for filling, by the electroplating of copper, a cavity in a semiconductor substrate such as a "through-via" structure for the production of interconnects in three-dimensional integrated circuits, characterized in that it comprises in solution in a solvent:
- copper ions in a concentration lying between 45 and 1500 mM;
- a complexing agent for the copper comprising at least one compound chosen from aliphatic polyamines having 2 to 4 amino groups, preferably ethylenediamine, in a concentration lying between 45 and 3000 mM;
- the molar ratio of the copper to said complexing agent lying between 0.1 and 5;
- thiodiglycolic acid in a concentration lying between 1 and 500 mg/l; and
- optionally a buffer system, in particular ammonium sulfate, in a concentration lying between 0.1 and 3M.

The term "electroplating" here is understood to mean any process in which a substrate is electrically biased and placed in contact with a liquid containing precursors of a metal, such as in particular copper, with a view to depositing said metal on the surface of said substrate. When the substrate is an electrical conductor, the electroplating is carried out for example by passing a current between the substrate to be coated, which forms one electrode (the cathode in the case of a metal or organometal coating), and a second electrode (the anode) placed in a bath containing a source of precursors of the material to be deposited (for example metal ions in the case of a metal coating) and optionally various agents intended to improve the properties of the coating formed (uniformity and smoothness of the deposit, resistivity, etc.), optionally with a reference electrode being present. By international convention, the current flowing through and the voltage applied to the substrate of interest, i.e. the cathode of the electrochemical circuit, are negative. In the whole of this text, when these currents and voltages are mentioned with a positive value, it is understood that this value represents the absolute value of said current or said voltage.

The electroplating compositions according to the present invention can be employed whatever the production sequence of the three-dimensional circuits (metallization before or after the step of thinning the silicon wafer).

It has been shown that these compositions allow cavities or vias having high aspect ratios, of 5:1 and above, to be filled without material defect.

Although there is no restriction in principle on the nature of the solvent (provided that it sufficiently dissolves the active species in the solution and does not interfere with the electroplating), it is preferably water.

Generally, the electroplating composition according to the invention comprises a source of copper ions, in particular cupric ions Cu²⁺.

Advantageously, the source of copper ions is a copper salt such as in particular copper sulfate, copper chloride, copper nitrate, copper acetate, preferably copper sulfate and even more preferably copper sulfate pentahydrate.

According to a particular feature, the copper ions are present within the electroplating composition in a concentration lying between 45 and 500 mM, preferably between 100 and 300 mM.

The electroplating composition according to the invention comprises a complexing agent consisting of one or more compounds chosen from the aliphatic polyamines having from 2 to 4 amino groups -NH₂ preferably aliphatic polyamines having 2 amino groups.

Among the aliphatic polyamines that may be used, mention may be made of ethylenediamine, diethylenetriamine, triethylenetetramine and dipropylenetriamine and preferably ethylenediamine.

The concentration of complexing agent within compositions according to the invention generally lies between 45 and 3000, preferably between 45 and 1500 mM, more preferably between 300 and 900 mM.

The molar ratio of the copper to the complexing agent generally lies between 0.1 and 5, preferably between 0.1 and 1 and even more preferably between 0.2 and 0.4.

It has been observed that excellent results are obtained according to the invention when the complexing agent is used in excess compared to copper, and particularly when a part of the complexing agent in excess is in a protonated form in the electroplating solution.

Thus, in this case, the complexing of a copper ion requires four amino functions, the molar ratio of the copper to the complexing agent will generally be below 0.5 when the complexing agent comprises two amino groups, below 0.33 when it comprises three amino groups and below 0.25 when it comprises four amino groups.

Complexing agents comprising two amino groups are particularly preferred and will be used in quantities such that the molar ratio of the copper to the complexing agent is between 0.1 and 0.5, preferably between 0.2 and 0.4.

In the context of the present invention, ethylenediamine is a particularly preferred complexing-agent compound and excellent results have been obtained using compositions in which this compound is present in a concentration lying between 300 and 900 mM, in particular when the molar ratio of the copper ions to the ethylenediamine lies between 0.2 and 0.4.

When the molar ratio of the copper to ethylenediamine is between 0.1 and 0.5, preferably between 0.2 and 0.4, the ethylenediamine in excess in the solution can be in a free form or a protonated form. It has been observed that in order to obtain a nonconformal deposition or to even better improve the filling, it is desirable that the molar ratio of free ethylenediamine to total ethylenediamine in a solution (either in a protonated or non-protonated form) is between 0.2 and 3. Compositions according to the invention are especially characterized by the fact that they contain thiodiglycolic acid.

It has been discovered that, in compositions according to the invention, thiodiglycolic acid favors a nonconformal growth of the copper by an "accelerator" effect, i.e. by catalyzing the growth rate of the copper at the bottom of the cavity to be filled, especially "through-via" type structures. This effect, known as the bottom-up effect, guarantees an excellent fill of said cavity, with copper, with no voids being formed.

Advantageously, thiodiglycolic acid is present, within electroplating compositions according to the invention, in a concentration lying between 1 and 500 mg/l, preferably between 1 and 100 mg/l.

Ammonium sulfate, which is an optional element in compositions according to the invention, acts as a pH buffer, and therefore allows fluctuations in the pH to be limited during the filling of the cavity with copper.

When present within compositions according to the invention, ammonium sulfate may be used in a concentration lying between 0.1 and 3M, preferably between 0.5 and 2M, even more preferably between 1 and 1.5M.

Advantageously, the pH of the compositions according to the invention will lie between 7 and 12, preferably between 8.5 and 11.5.

The pH of the composition may optionally be adjusted within the desired pH range by means of one or more pH-modifying compounds (or buffers) other than ammonium sulfate, such as described in the "Handbook of Chemistry and Physics - 84th edition" David R. Lide, CRC Press.

The electroplating compositions according to the invention may also contain other constituents such as in particular suppressor compounds, especially polyethylene glycols such as PEG 8000.

Advantageously, the electroplating compositions according to the invention can furthermore comprise at least one polymer having amino functions, and in particular polyethyleneimine, in an amount comprised between 5 and 250 mg/l.

It has been observed that such compounds favor a nonconformal deposition of copper, the thickness of the copper layer at the bottom of the cavity to be filled being thicker than the copper deposition on the top flat part of the cavity. Such an effect is particularly advantageous, since it limits the amount of copper to be eliminated during the later polishing of the top flat surface of the cavity. Excellent results have been obtained in this respect by using polyetheleneimine with an average molecular mass between 500 and 900 g/mol, preferably used in an amount ranging between 15 and 150 mg/l.

According to a second aspect, the subject of the present invention is the use of an electroplating composition such as defined above to fill a cavity in a semiconductor substrate such as a through-via structure with copper for the production of interconnects in three-dimensional integrated circuits.

It has been observed that it is possible, using compositions according to the invention, to obtain a fill of excellent quality in cavities the surface of which is formed either by a traditional or nickel-based copper-diffusion barrier layer, or by a copper seed layer covering such a barrier layer.

According to a third aspect, the subject of the present invention is a process for filling the cavity in a semiconductor substrate, in particular a through-via for the production of interconnects in three-dimensional integrated circuits, said cavity being covered by a copper-diffusion barrier layer, in particular based on nickel, optionally itself covered with a copper seed layer, characterized in that it comprises placing said surface of the cavity in contact with an electroplating composition as defined above, and a step during which said surface is biased for a long enough time to allow said cavity to be filled.

The step of filling by electroplating is carried out for a sufficient length of time to form the desired coating. This length of time may be easily defined by a person skilled in the art, the growth of the film being a function of the charge, which is also equal to the integral over time of the current passed through the circuit during the deposition (Faraday's law).

During the filling step, the surface of the cavity to be filled may be biased, either in galvanostatic mode (with a fixed set current) or in potentiostatic mode (with a fixed set potential, optionally relative to a reference electrode) or else in pulsed mode (either the current or the voltage being pulsed).

According to one currently preferred embodiment of the invention, the bias of the surface of the cavity to be filled is produced in DC mode by applying a current per unit area lying in a range from 0.2 mA/cm² to 50 mA/cm², preferably from 0.5 mA/cm² to 5 mA/cm².

Acidic electroplating solutions, which are commonly used in the prior art, are likely to damage seed layers and barrier layers. Therefore, these solutions must preferably be used in a process comprising an initial step called a "hot entry" step, in which the surface to be coated is placed in contact with the electroplating bath under electrical bias. Such a step is particularly difficult to implement, as the entry of the surface to be coated into the chemical solution needs to be precisely controlled in order to prevent disruption of the applied electrical bias.

The electrodeposition compositions according to the invention, due to their unaggressive nature with respect to the seed layers and barrier layers, may be implemented in such a process comprising an initial "hot entry" step, but in a particularly advantageous way they may also be implemented in a process comprising an initial "cold entry" step, in which the electrically unbiased surface to be coated is placed in contact with the electrodeposition bath and maintained in this state for the desired length of time. This embodiment has the advantage of being very simple to implement since it requires no particular control during the entry of the surface to be coated into the electrodeposition chemical solution.

Thus, according to a particular feature, the process according to the invention comprises, before the electrodeposition, a "cold entry" step during which the surface of the cavity to be filled is placed in contact with the electrodeposition composition according to the invention without electrical bias, and optionally maintained in this state for at least 30 seconds.

According to another particularly advantageous feature, the filling process according to the invention may be implemented at a temperature lying between 20 and 30°C, i.e. at room temperature. It is therefore not necessary to heat the electrodeposition bath which is an advantage of the process from the standpoint of the simplicity of the process.

According to yet another particularly advantageous feature of the process according to the invention, during the filling of the cavity, the substrate is rotated at a speed lying between 20 and 600 revolutions per minute, preferably at a rotation speed lying between 100 and 400 revolutions per minute.

This is because it has been observed, quite surprisingly and unexpectedly, that increasing the rotation speed of the substrate during the filling of the cavity, above the rotation speeds commonly used, which are about 20 to 80 rpm, has the effect of improving the filling kinetics of the cavity and of limiting the growth of the copper on flat regions located above the cavities (overburden). Limiting this overburden especially allows the time required for the subsequent polishing of the substrate to be reduced, and consequently the cost of fabricating the integrated circuit to be reduced. Excellent results have been obtained in this context when the substrate is rotated at a speed lying between 100 and 400 revolutions per minute.

Improvement in the speed of the filling of the cavity and the limitation of the growth of copper on the flat areas situated on top of said cavities were observed when the electroplating solution is agitated by any means, for example through a large fluid flow in the electroplating tank or the recirculation of the electroplating solution.

In a general manner and without limitation by theoretical interpretation, any means making it possible to increase the agitation of the solution can therefore be used in addition to or by the replacement of an increased rotational speed.

The process according to the invention has allowed excellent-quality copper fills to be produced, without material defect, and which do not generate contaminants in large quantities.

This process may be used to fill a cavity the surface of which consists of a copper seed layer.

Advantageously, the process according to the invention may also be used to fill a cavity the surface of which consists of a material forming a barrier to the diffusion of the copper.

Such a layer forming a barrier to the diffusion of the copper may comprise at least one material chosen from tantalum (Ta), titanium (Ti), tantalum nitride (TaN), titanium nitride (TiN), tungsten (W), titanium tungsten (TiW) and tungsten-carbon-nitride (WCN).

It has also been shown that the process according to the invention may also be used to fill a cavity the surface of which consists of a nickel-based material such as NiB forming a barrier to the diffusion of the copper. Such a copper-diffusion barrier layer may be produced for example by following the process described in document WO 2010/001054.

The present invention will now be illustrated by the following nonlimiting examples, in which compositions according to the invention are used to fill "through-via" type structures, coated with a copper-diffusion barrier layer, with copper. These examples are especially applicable to the fabrication of interconnection structures made of copper for integrated circuits.

These examples refer to the appended figures which respectively show:
- figure 1: a scanning electron micrograph showing through-vias partially filled with copper according to example 1;
- figure 2: a scanning electron micrograph showing through-vias partially filled with copper according to example 2;
- figure 3: a scanning electron micrograph showing through-vias partially filled with copper according to example 3;
- figure 4: a scanning electron micrograph showing through-vias filled with copper according to example 4;
- figure 5: a scanning electron micrograph showing through-vias partially filled with copper according to example 5;
- figure 6A: a TOF-SIMS carbon concentration profile as a function of depth measured for copper deposits produced according to example 6 using a composition according to the invention and a commercially-available composition;
- figure 6B: a TOF-SIMS sulfur concentration profile as a function of depth measured for copper deposits produced according to example 6 using a composition according to the invention and a commercially-available composition; and
- figure 6C: a TOF-SIMS chlorine concentration profile as a function of depth measured for copper deposits produced according to example 6 using a composition according to the invention and a commercially-available composition.

In these examples, unless otherwise indicated, the temperature is room temperature (20 to 30°C).
- figure 7: a scanning electron microscope view showing through-vias partially filled with copper according to example 9;
- figure 8: a chronopotentiometry graph obtained by successively adding thiodiglycolic acid according to example 11;
- figure 9: a graph showing the accelerator effect (in percentage) according to the amount of thiodiglycolic acid;
- figure 10: a voltammogram obtained according to example 12.

### EXAMPLE 1: Partial filling of vias with copper, using a composition according to the invention based on an ethylenediamine-copper complex, on a tantalum-based barrier layer on which a copper seed layer has been deposited.

### A. Material and equipment

### Substrate:

The substrate used in this example was made of a 750 µm-thick 4 cm × 4 cm piece of silicon etched with "through-via" type cylindrical patterns having a depth of 25 µm and a diameter of 5 µm.

These patterns were covered with a 400 nm-thick layer of silica, itself coated with a tantalum-based layer deposited by sputter PVD (physical vapor deposition), and which was divided into two sublayers of tantalum nitride (15 nm) and of tantalum (10 nm).

This TaN/Ta "bilayer" forms a barrier to the diffusion of the copper such as used in the structures called "through-vias" in the fabrication of integrated circuits.

A conformal copper seed layer having a thickness of about 200 nm was deposited on the patterns.

### Filling solution:

The filling solution used in this example was an aqueous solution containing 18 g/l (or 0.3M) of ethylenediamine, 198 g/l (or 1.5M) of ammonium sulfate, 10 mg/l of thiodiglycolic acid, and 25 g/l (or 0.1M) of CuSO₄(H₂O)₅. The pH of the solution was 8.8.

### Equipment:

In this example, an electrolytic deposition tool representative of those employed in the microelectronics industry was used, it was a Semitool^{®} tool of the Equinox™ type and capable of processing 200 mm-diameter wafers.

This tool contained an electrolytic deposition cell in which the seed layer was deposited and a rinsing/drying station used post-deposition.

The electrolytic deposition cell contained an anode which could be made either of an inert metal (platinum-coated titanium for example), or of a metal identical to that forming the seed layer, in this case copper. The silicon wafer coated by the TaN/Ta barrier layer formed the cathode of this cell.

This cell furthermore contained a stabilized electrical power supply allowing as much as 120 V and 15 A to be supplied and a device for electrical connection of the cathode physically isolated from the solution by a seal. This electrical connection device was generally annular and allowed the substrate to be supplied through several contact points spaced regularly over this substrate.

It also contained a device for holding the wafer to be coated comprising means for rotating said wafer at a preset speed.

### B. Experimental method

A chemical treatment was carried out before starting the electrodeposition process. The object of this treatment was to increase the wettability of the filling solution in the vias and to remove air bubbles. It is possible for example to immerse the piece in the filling solution and place the whole in an ultrasonic bath for at least 2 minutes (5 minutes in this example).

The electrodeposition process employed in this example comprised the various consecutive steps that follow.

### Step 1: "Cold entry"

This step may be divided into two substeps:
1.1. The aforementioned substrate was introduced into the electrolytic deposition cell in such a way that the side comprising the copper seed layer made contact with the electrical connection device - the latter was still not supplied with electricity.
1.2. The assembly formed by the electrical connection device and the substrate, which will be called from now on the "cathode assembly", was placed in contact, for example by dipping, with the filling solution. This contact, which generally lasted for 5 seconds or less (2 seconds in this example) was made whilst the device was still not supplied with electricity.

### Step 2: Filling of the vias

The cathode assembly was then biased in galvanostatic mode and simultaneously rotated at a speed of 20 to 100 revolutions per minute (20 revolutions per minute for example).

The use of the galvanostatic method made it possible to apply a current per unit area generally lying between 0.5 and 3.4 mA/cm² (0.6 mA/cm² in the example).

Under the aforementioned conditions, the time necessary to partially fill the 5 µm-diameter, 25 µm-deep vias was 90 minutes.

The term "partially" is understood to mean that the via was filled enough for the bottom-up effect, characterizing a defectless fill, to be observed.

### Step 3: "Cold exit"

This step may be divided into two substeps:
3.1. After the filling step, the copper-coated cathode assembly was removed from the filling solution at a rotation speed of zero, the system no longer being supplied with electricity.

The rotation speed was then increased to 500 revolutions per minute for 10 seconds.

A pre-rinse in deionized water was carried out in the cell.
3.2. The substrate coated with the seed layer was then transferred into the rinsing/drying module in order to be rinsed in deionized water.

The rinse water was drained and then drying was carried out under flowing nitrogen.

The rotation was then stopped so as to allow the dried, coated substrate to be removed.

### C. Results obtained

By applying the experimental method given above, partial filling of the 5 µm-diameter, 25 µm-deep vias with copper was obtained with a bottom-up effect, characterizing defectless filling of the vias.

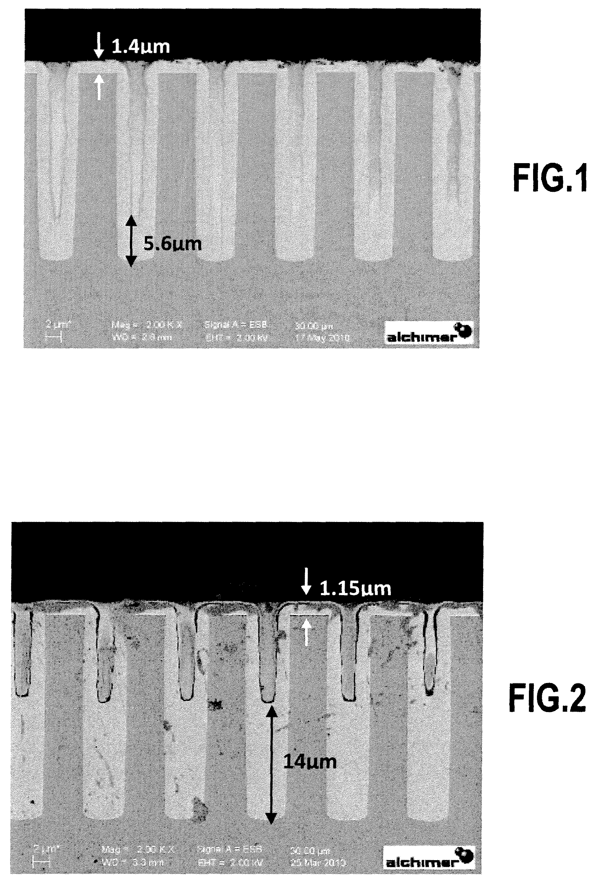

This effect was observed using a scanning electron microscope (SEM) (2k magnification) (see figure 1).

As may be clearly seen in this figure, the thickness of the copper deposition at the cavity bottom (5.6 µm) is much greater than the thickness of the copper deposited on the surface of the silicon wafer (1.4 µm).

### EXAMPLE 2: Partial filling of vias with copper, using a composition according to the invention based on an ethylenediamine-copper complex, on a tantalum-based barrier layer on which a copper seed layer has been deposited.

### A. Material and equipment

### Substrate:

The substrate used in this example was identical to that of example 1.

### Filling solution:

The solution used in this example was identical to that of example 1.

### Equipment:

In this example an electrolytic deposition tool similar to the fountain cells used in the microelectronics industry was used.

The electrolytic deposition cell contained an anode which could be made either of an inert metal (platinum-coated titanium for example), or of a metal identical to that deposited, in this case copper. The silicon wafer coated by the TaN/Ta barrier layer, itself coated with a copper seed layer, formed the cathode of this cell.

This two-electrode system was supplied with power using a VMP2 potentiostat which allowed as much as 20 V and 0.5 A to be supplied. This system contained a device for electrical connection of the cathode physically isolated from the solution by a seal. This electrical connection device was generally annular and allowed the substrate to be supplied through several contact points spaced regularly over this substrate.

This system also contained a device for holding the wafer to be coated comprising means for rotating said wafer at a preset speed.

### B. Experimental method

A chemical treatment, identical to that of example 1, was carried out before starting the electrodeposition process, with the object of increasing the wettability of the filling solution in the vias and of removing air bubbles.

The electrodeposition process employed in this example comprised the various consecutive steps that follow.

### Step 1: "Cold entry"

This step was identical to that described in example 1.

### Steep 2: Filling of the vias

The cathode assembly was biased in galvanostatic mode and simultaneously rotated at a speed of 60 revolutions per minute.

The use of the galvanostatic method made it possible to apply a current per unit area of 1 mA/cm².

Under the aforementioned conditions, the time necessary to partially fill the 5 µm-diameter, 25 µm-deep vias was 90 minutes.

### Step 3: "Cold exit"

This step was identical to that described in example 1.

### C. Results obtained

By applying the experimental method given above, partial filling of the 5 µm-diameter, 25 µm-deep vias with copper was obtained with a bottom-up effect.

This effect was observed using a scanning electron microscope (SEM) (2k magnification) (see figure 2).

As may be clearly seen in this figure, the thickness of the copper deposition at the cavity bottom (14 µm) is much greater than the thickness of the copper deposited on the surface of the silicon wafer (1.15 µm).

### COMPARATIVE EXAMPLE 3: Partial filling of vias with copper, using a composition based on an ethylenediamine-copper complex without thiodiglycolic acid, on a tantalum-based barrier layer on which a copper seed layer has been deposited.

### A. Material and equipment

### Substrate:

The substrate used in this example was identical to that of example 1.

### Filling solution:

The filling solution used in this example was an aqueous solution containing 18 g/l (or 0.3M) of ethylenediamine, 198 g/i (or 1.5M) of ammonium sulfate, and 25 g/l (or 0.1M) of CuSO₄(H₂O)₅. The pH of the solution was 8.9.

### Equipment:

The equipment used in this example was identical to that of example 2.

### B. Experimental method

The experimental method used in this example was identical to that of example 2.

### C. Results obtained

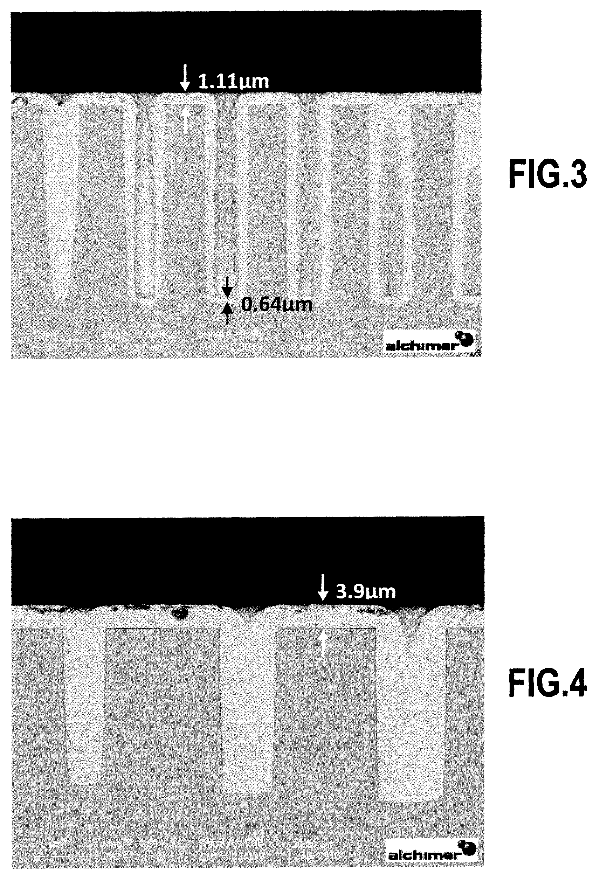

By applying the experimental method given above, it was not possible to obtain good-quality partial filling of the vias, as no bottom-up effect was observable using the scanning electron microscope (SEM) (2k magnification) (see figure 3).

As may be clearly seen in this figure, the thickness of the copper deposition at the cavity bottom (0.64 µm) is smaller than the thickness of the copper deposited on the surface of the silicon wafer (1.11 µm).

This example shows how critical the presence of thiodiglycolic acid is within electrodeposition compositions according to the invention.

### EXAMPLE 4: Filling of vias with copper, using a composition according to the invention based on an ethylenediamine-copper complex on a nickel-based (NiB) barrier layer.

### A. Material and equipment

### Substrate:

The substrate used in this example was made of a 750 µm-thick 4 cm × 4 cm piece of doped (p-type) silicon etched with "through-via" type cylindrical patterns of three different sizes:
- depth 25 µm and diameter 7 µm;
- depth 27 µm and diameter 9 µm; and
- depth 28 µm and diameter 11 µm.

Using the process described in document WO 2010/001054, a 50 nm-thick layer of conformal NiB, forming a barrier to the diffusion of the copper, was deposited on the surface of the substrate.

### Filling solution:

The solution used in this example was identical to that of example 1.

### Equipment:

The equipment used in this example was identical to that of example 2.

### B. Experimental method

The experimental protocol used in this example was identical to that in example 2 except that the filling was carried out for 180 minutes.

### C. Results obtained

By applying the experimental method given above, an excellent-quality fill of the vias was obtained, which was observed using a scanning electron microscope (2k magnification) (see figure 4).

As may be seen in this figure, the fill of the vias was of excellent quality, no material defect being visible.

### COMPARATIVE EXAMPLE 5: Filling of vias with copper, using a composition based on an ethylenediamine-copper complex without thiodiglycolic acid and ammonium sulfate, on a tantalum-based barrier layer on which a copper seed layer has been deposited.

### A. Material and equipment

### Substrate:

The substrate used in this example was identical to that of example 1.

### Filling solution:

The filling solution used in this example was an aqueous solution containing 8 g/l (or 0.133M) of ethylenediamine, and 16 g/l (or 0.064M) of CuSO₄(H₂O)₅. The pH of the solution was 6.8.

### Equipment:

The equipment used in this example was identical to that of example 2.

### B. Experimental method

The experimental method used in this example was identical to that of example 2.

### C. Results obtained

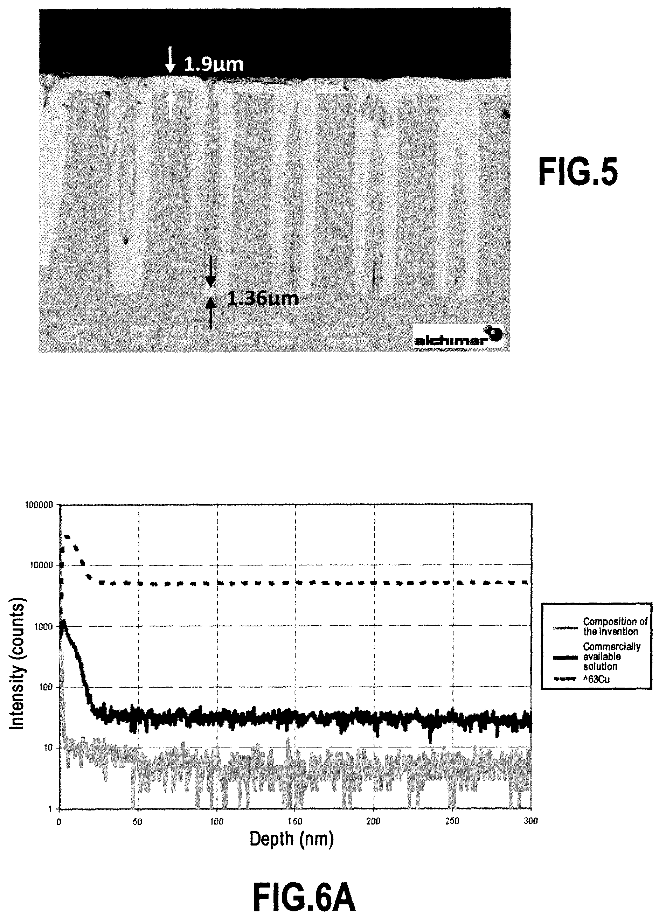

By applying the experimental method given above, it was not possible to obtain a good-quality, partial fill of the vias, no "bottom-up" effect was observed using the scanning electron microscope (2k magnification) (see figure 5).

As may be clearly seen in this figure, the thickness of the copper deposition at the cavity bottom (1.36 µm) is smaller than the thickness of the copper deposited on the surface of the silicon wafer (1.9 µm).

### EXAMPLE 6: Deposition of copper, using a composition according to the invention based on an ethylenediamine-copper complex, on a nickel-based (NiB) barrier layer, and comparison with the same deposition using a commercially-available electrolytic copper solution (Microfab® DVF 200 Enthone Inc.)

### A. Material and equipment

### Substrate:

The substrate used in this example was made of a 750 µm-thick 4 cm × 4 cm piece of silicon with no etched patterns.

A 50 nm-thick conformal layer of NiB, forming a barrier to the diffusion of the copper, was deposited on this substrate using the process described in document WO 2010/001054.

### Deposition solution:

The electroplating composition used in this example was identical to that of example 1.

By way of comparison, a commercially-available electrolytic-copper solution having a pH lower than 1 was used, in this case Microfab DVF 200 make-up^{®} solution containing 7 mL/L of Microfab DVF 200C, 5.5 mL/L of Microfab DVF 200B and 0.25 mL/L of TP wetter.

### Equipment:

The equipment used in this example was identical to that of example 2.

### B. Experimental method

The electrodeposition process employed in this example comprised the various consecutive steps that follow.

### Step 1: "Cold entry"

This step was identical to that described in example 1.

### Steep 2: Deposition of copper

The cathode assembly was biased in galvanostatic mode and simultaneously rotated at a speed of 60 revolutions per minute.

In the case of the deposition using the composition according to the invention, the use of the galvanostatic method made it possible to apply a current per unit area of 1 mA/cm².

In the case of the deposition using the commercially-available electrolytic-copper solution (Microfab DVF 200 Enthone Inc.), the use of the galvanostatic method made it possible to apply a current per unit area of 10 mA/cm², as recommended by the supplier of this product.

### Step 3: "Cold exit"

This step was identical to that described in example 1.

### C. Results obtained

Using a time-of-flight secondary ion mass spectrometer (TOF-SIMS) (ION TOF model IV), the composition of the deposits was evaluated depthwise using the following experimental conditions: source of abrasion ions: Cs⁺ at 2 kV over 300 × 300 µm²; source of primary analysis ions: Au⁺ at 25 kV over 100 × 100 µm².

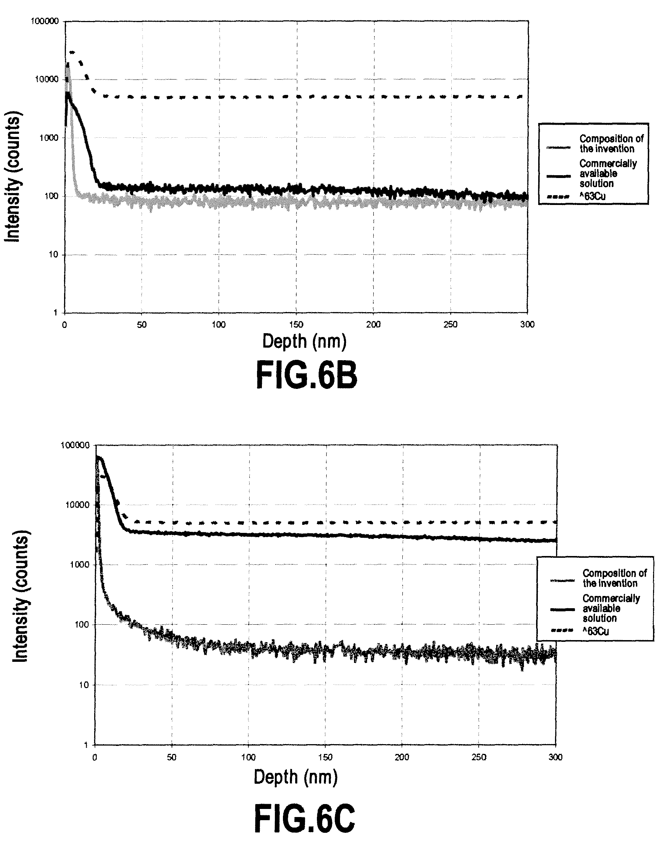

The results obtained, which are illustrated in Figures 6A, 6B and 6C, show a smaller amount of carbon, sulfur and chlorine in the deposit produced using the composition according to the invention compared to a deposit produced using the commercially-available electrolytic-copper solution (Microfab DVF 200 Enthone Inc.).

This example shows that the electroplating compositions according to the invention are particularly advantageous in that their use does not generate contaminants, in particular carbon, sulfur and chlorine, in large amounts. This ensures that microelectronic devices fabricated using the invention are more reliable.

### EXAMPLE 7: Deposition of copper, using a composition according to the invention based on an ethylenediamine-copper complex, on a nickel-based (NiB) barrier layer

### A. Material and equipment

### Substrate:

The substrate used in this example was made of a 750 µm-thick 4 cm × 4 cm piece of (p-type) doped silicon etched with "through via" type cylindrical patterns having six different sizes:
- depth 38 µm and diameter 3.2 µm;
- depth 44 µm and diameter 4.4 µm;
- depth 47 µm and diameter 5 µm;
- depth 52 µm and diameter 8 µm;
- depth 56 µm and diameter 10 µm;
- depth 58 µm and diameter 12 µm;

Using the process described in document WO 2010/001054, a 50 nm-thick layer of conformal NiB, forming a barrier to the diffusion of the copper, was deposited on the surface of the substrate.

### Deposition solution:

The filling solution used in this example was an aqueous solution containing 36 g/l (or 0.6M) of ethylenediamine, 0.05M of which was protonated using sulfuric acid, 40 mg/l of thiodiglycolic acid, and 50 g/l (or 0.2M) of CuSO₄(H₂O)₅. The pH of the solution was 11.2.

### Equipment:

The equipment used in this example was identical to that of example 2.

### B. Experimental method

The electrodeposition process employed in this example comprised the various consecutive steps that follow.

### Step 1: "Cold entry"

This step was identical to that described in example 1.

### Step 2: Deposition of copper

The cathode assembly was biased in galvanostatic mode and simultaneously rotated at a speed of 600 revolutions per minute.

In the case of the deposition using the composition according to the invention, the use of the galvanostatic method made it possible to apply a current per unit area of 1.45 mA/cm².

### Step 3: "Cold exit"

This step was identical to that described in example 1.

### C. Results obtained

By applying the experimental method given above a good bottom-up effect was obtained (observed using the scanning electron microscope) in all the vias of different sizes. The filling of the cavities was almost complete whereas the thickness of the copper deposited on the surface of the silicon wafer was about 1.6 µm.

### EXAMPLE 8: Deposition of copper, using a composition according to the invention based on an ethylenediamine-copper complex, on a nickel-based (NiB) barrier layer

### A. Material and equipment

### Substrate:

The substrate used in this example was identical to that of example 7.

### Deposition solution:

The filling solution used in this example was an aqueous solution containing 36 g/l (or 0.6M) of ethylenediamine, 0.15M of which was protonated using sulfuric acid, 40 mg/l of thiodiglycolic acid, and 50 g/l (or 0.2M) of CuSO₄(H₂O)₅. The pH of the solution was 9.7.

### Equipment:

The equipment used in this example was identical to that of example 2.

### B. Experimental method

The electrodeposition process employed in this example comprised the various consecutive steps that follow.

### Step 1: "Cold entry"

This step was identical to that described in example 1.

### Step 2: Deposition of copper

The cathode assembly was biased in galvanostatic mode and simultaneously rotated at a speed of 600 revolutions per minute.

In the case of the deposition using the composition according to the invention, the use of the galvanostatic method made it possible to apply a current per unit area of 1.45 mA/cm².

### Step 3: "Cold exit"

This step was identical to that described in example 1.

### C. Results obtained

By applying the experimental method given above a good bottom-up effect was obtained (observed using the scanning electron microscope) in all the vias of different sizes. The filling of the cavities was almost complete, whereas the thickness of the copper deposited on the surface of the silicon wafer was about 1.4 µm.

### EXAMPLE 9: Deposition of copper, using a composition according to the invention based on an ethylenediamine-copper complex, on a nickel-based (NiB) barrier layer

### A. Material and equipment

### Substrate:

The substrate used in this example was identical to that of example 7.

### Deposition solution:

The filling solution used in this example was an aqueous solution containing 36 g/l (or 0.6M) of ethylenediamine, 0.18M of which was protonated using sulfuric acid, 22 mg/l of thiodiglycolic acid, 110 mg/l of polyethyleneimine (PEI Mw 800) and 50 g/l (or 0.2M) of CuSO₄(H₂O)₅. The pH of the solution was 9.1.

### Equipment:

The equipment used in this example was identical to that of example 2.

### B. Experimental method

The electrodeposition process employed in this example comprised the various consecutive steps that follow.

### Step 1: "Cold entry"

This step was identical to that described in example 1.

### Step 2: Deposition of copper

The cathode assembly was biased in galvanostatic mode and simultaneously rotated at a speed of 600 revolutions per minute.

In the case of the deposition using the composition according to the invention, the use of the galvanostatic method made it possible to apply a current per unit area of 1 mA/cm².

### Step 3: "Cold exit"

This step was identical to that described in example 1.

### C. Results obtained

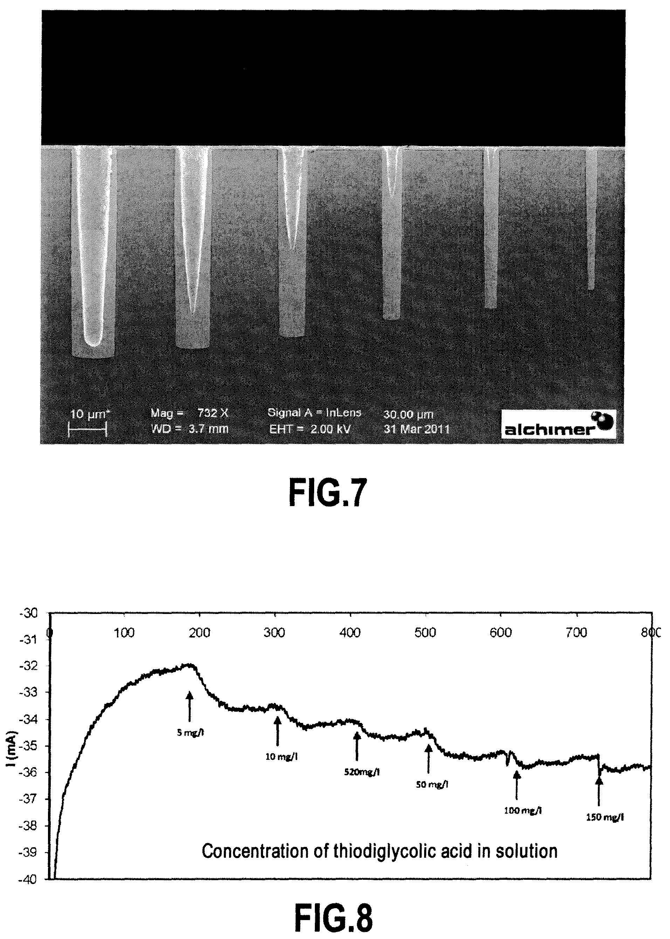

By applying the experimental method given above a good bottom-up effect was obtained, observed using the scanning electron microscope, in all the vias of different sizes (see Figure 7).

In this example, the thickness of the copper deposited on the surface of the silicon wafer was about 0.9 µm.

By reproducing example 9 with the same electrolyte but with the PEI removed, the thickness of the copper deposited on the surface of the silicon wafer was substantially larger than this value of 0.9 µm

Thus the use of polyethyleneimine in the electrodeposition solution potentiates the accelerating effect of the thiodiglycolic acid, favoring a nonconformal deposition of the copper.

### EXAMPLE 10: Deposition of copper, using a composition according to the invention based on an ethylenediamine-copper complex, on a nickel-based (NiB) barrier layer

### A. Material and equipment

### Substrate:

The substrate used in this example was identical to that of example 7.

### Deposition solution:

The filling solution (electrolyte) used in this example was an aqueous solution containing 108 g/l (or 1.4M) of ethylenediamine, 0.1M of which was protonated using sulfuric acid, 120 mg/l of thiodiglycolic acid, and 150 g/l (or 0.6M) of CuSO₄(H₂O)₅. The pH of the solution was 10.4.

### Equipment:

The equipment used in this example was identical to that of example 2.

### B. Experimental method

The electrodeposition process employed in this example comprised the various consecutive steps that follow.

### Step 1: "Cold entry"

This step was identical to that described in example 1.

### Step 2: Deposition of copper

The cathode assembly was biased in galvanostatic mode and simultaneously rotated at a speed of 600 revolutions per minute.

In the case of the deposition using the composition according to the invention, the use of the galvanostatic method made it possible to apply a current per unit area of 4.3 mA/cm².

### Step 3: "Cold exit"

This step was identical to that described in example 1.

### C. Results obtained

By applying the experimental method given above a good bottom-up effect was obtained, observed using the scanning electron microscope, in all the vias of different sizes. The filling of the cavities was almost complete, whereas the thickness of the copper deposited on the surface of the silicon wafer was about 1.4 µm.

### EXAMPLE 11: Demonstration of the accelerating effect of thiodiglycolic acid in a solution based on a mixture of copper and ethylenediamine on a copper-based substrate. A. Material and equipment

### Substrate:

The substrate used in this example was made of a 750 µm-thick 2 cm × 4 cm silicon wafer.

This silicon wafer was coated with a tantalum-based layer deposited by PVD (physical vapor deposition), and which was divided into two sublayers of tantalum nitride (15 nm) and of tantalum (10 nm). A 50 nm-thick copper layer was then deposited by PVD sputtering.

### Deposition solution:

The electrolyte used in this example was an aqueous solution containing 36 g/l (or 600 mM) of ethylenediamine, 50 g/l (or 200 mM) of CuSO₄(H₂O)₅, and an amount of 5 to 150 ppm of thiodiglycolic acid was gradually added to the solution.

### Equipment:

In this example, a glass cell was used which contained an anode which was a platinum sheet, the silicon wafer coated with the copper layer forming the cathode of this cell.

This two-electrode system was supplied with electricity using a VMP2 potentiostat which made it possible to supply as much as 20 V and 0.5 A.

The two electrodes were placed in a bath intended to contain the electrolyte.

A micropipette was used to make successive additions of a thiodiglycolic acid stock solution.

The cell thus equipped was placed in a magnetic stirrer, and a magnetic bar was introduced so as to rapidly homogenize the solution during the successive additions of thiodiglycolic acid solution.

### B. Experimental method

In this example, a DC potential of 2.5 V was applied using the VMP2 potentiostat throughout the experiment (before and after successive additions of thiodiglycolic acid). The chronopotentiometry graph (current as a function of time) thus obtained made it possible to evaluate the resulting current as a function of the amount of additive added. This current characterizes the relative accelerating effect of the solute additive. The current obtained from the additive-free solution made it possible to normalize the resulting current values, and therefore to evaluate the accelerating effect of the additive as a function of its concentration in solution.

### C. Results obtained

By applying the experimental method given above and by making successive additions of thiodiglycolic acid, it was possible to compare the values of the resulting current after each addition, and to determine the variation relative to the additive-free solution, thereby making it possible to demonstrate the accelerating effect of the additive.

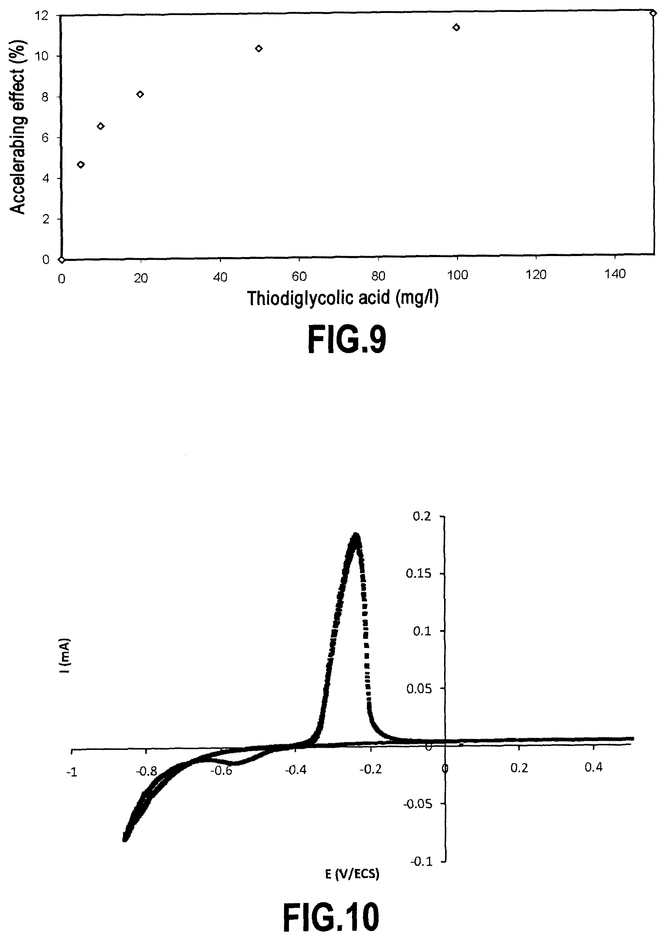

Thus, figure 8 shows the chronopotentiometry graph obtained as a function of the additions of thiodiglycolic acid. This graph clearly shows the gradual change of the current to cathode currents as successive additions of thiodiglycolic acid are made, which is characteristic of an accelerating effect. Figure 9 allows the accelerating effect of the thiodiglycolic acid to be quantified as a function of its concentration in solution, and it is thus observed that the accelerating effect of this compound may reach 12%.

### EXAMPLE 12: Demonstration of the accelerating effect of thiodiglycolic acid in a solution based on a mixture of copper and ethylenediamine on a copper-based substrate.

### A. Material and equipment

### Substrate:

The substrate used in this example was made of a 1 mm-diameter platinum electrode.

### Electrolyte:

The electrolyte used in this example was an aqueous solution containing 36 g/l (or 600 mM) of ethylenediamine, 50 g/l (or 200 mM) of CuSO₄(H₂O)₅, and 10 ppm of thiodiglycolic acid.

### Equipment:

In this example a glass cell was used which contained a counter electrode (a platinum sheet) and a saturated calomel reference electrode, the platinum electrode forming the working electrode of this cell.

This three-electrode system was supplied with electricity using a VMP2 potentiostat which made it possible to supply as much as 20 V and 0.5 A.

The three electrodes were placed in a bath intended to contain the electrolyte.

### B. Experimental method

In this example, the potential was varied at a rate of 50 mV/s, using the VMP2 potentiostat, from 0 V/SCE and ranging to cathode potentials as low as -0.85 V/SCE, before returning to anode potentials as high as 0.5 V/SCE. The voltammogram (current as a function of the potential) thus obtained made it possible to evaluate the electrochemical activity of the system.

### C. Results obtained

By applying the experimental method given above, the voltammogram obtained (see figure 12) clearly shows the reduction wave of the copper-ethylenediamine complex (from 0 V/SCE and ranging to anode potentials) and therefore the deposition of copper on the surface of the substrate. Near the cathodic potentials, a peak is observed indicating the redissolution of the copper deposited on the surface of the substrate. This analysis method allowed the quantity of copper deposited on the substrate to be quantified.

## Claims

1. A composition especially intended for filling, by the electroplating of copper, a cavity in a semiconductor substrate such as a "through-via" structure for the production of interconnects in three-dimensional integrated circuits, **characterized in that** it comprises in solution in a solvent:
- copper ions in a concentration lying between 45 and 1500 mM;
- a complexing agent for the copper consisting of at least one compound chosen from aliphatic polyamines having 2 to 4 amino groups, preferably ethylenediamine, in a concentration lying between 45 and 3000 mM;
- the molar ratio of the copper to said complexing agent lying between 0.1 and 5;
- thiodiglycolic acid in a concentration lying between 1 and 500 mg/l; and
- optionally a buffer system, in particular ammonium sulfate, in a concentration lying between 0.1 and 3M.

2. The composition as claimed in claim 1, **characterized in that** the copper ion concentration lies between 45 and 500 mM, preferably between 100 and 300 mM.

3. The composition as claimed in either one of claims 1 and 2, **characterized in that** the aforementioned copper ions are cupric ions preferably derived from copper sulfate.

4. The composition as claimed in one of claims 1 to 3, **characterized in that** the complexing agent for the copper consists of at least one compound chosen from ethylenediamine, diethylenetriamine, triethylenetetramine and dipropylenetriamine.

5. The composition as claimed in one of claims 1 to 4, **characterized in that** the aforementioned complexing agent is ethylenediamine.

6. The composition as claimed in one of claims 1 to 5, **characterized in that** the complexing agent concentration lies between 45 and 1500 mM, preferably between 300 and 900 mM.

7. The composition as claimed in either one of claims 4 and 5, **characterized in that** the molar ratio of the copper to the complexing agent lies between 0.1 and 1, preferably between 0.2 and 0.4.

8. A composition as claimed in claim 7, **characterized in that** the molar ratio of the copper to the complexing agent lies between 0.2 and 0.4 and that a part of the complexing agent in excess is in a protonated state.

9. A process for filling a cavity in a semiconductor substrate, in particular a through-via for the production of interconnects in three-dimensional integrated circuits, said cavity being covered by a copper-diffusion barrier layer, in particular based on nickel, optionally itself covered with a copper seed layer, **characterized in that** it comprises placing said surface of the cavity in contact with an electroplating composition as claimed in one of claims 1 to 8, and a step during which said surface is biased for a long enough time to allow said cavity to be filled.

10. The process as claimed in claim 9, **characterized in that** the aforementioned bias is produced in DC mode by applying a current per unit area lying in a range from 0.2 mA/cm² to 50 mA/cm², preferably from 0.5 mA/cm² to 5 mA/cm².

11. The process as claimed in either of claims 9 and 10, **characterized in that** the placing of said surface in contact is carried out by cold entry.

12. The process as claimed in one of claims 9 to 11, **characterized in that** the filling of the cavity is carried out at a temperature lying between 20 and 30°C.

13. The process as claimed in one of claims 9 to 12, **characterized in that** during the filling of the cavity, the substrate is rotated at a speed lying between 20 and 600 revolutions per minute, preferably at a rotation speed lying between 100 and 400 revolutions per minute.

14. The process as claimed in one of claims 9 to 13, **characterized in that** the surface of the cavity to be filled consists of a material forming a barrier to the diffusion of the copper comprising at least one material chosen from tantalum (Ta), titanium (Ti), tantalum nitride (TaN), titanium nitride (TiN), tungsten (W), titanium tungsten (TiW) and tungsten-carbon-nitride (WCN).

15. The process as claimed in one of claims 9 to 13, **characterized in that** the surface of the cavity to be filled consists of a material forming a nickel-based barrier to the diffusion of the copper.

## Patentansprüche

1. Zusammensetzung, die insbesondere zum Füllen einer Aussparung in einem Halbleitersubstrat, wie zum Beispiel einer Durchgangsbohrungsstruktur zur Herstellung von Querverbindungen bei dreidimensionalen integrierten Schaltkreisen, mittels Galvanisieren von Kupfer vorgesehen ist, **dadurch gekennzeichnet, dass** sie in Lösung in einem Lösungsmittel umfasst:
- Kupferionen in einer Konzentration, die zwischen 45 und 1.500 mM liegt,
- einen Komplexbildner für das Kupfer, der aus wenigstens einer Verbindung, die aus aliphatischen Polyaminen mit 2 bis 4 Aminogruppen ausgewählt ist, vorzugsweise Ethylendiamin, besteht, in einer Konzentration, die zwischen 45 und 3.000 mM liegt,
- wobei das Molverhältnis des Kupfers zum Komplexbildner zwischen 0,1 und 5 liegt,
- Thiodiglycolsäure in einer Konzentration, die zwischen 1 und 500 mg/l liegt, und
- wahlweise ein Puffersystem, insbesondere Ammoniumsulfat, in einer Konzentration, die zwischen 0,1 und 3 M liegt.

2. Zusammensetzung nach Anspruch 1, **dadurch gekennzeichnet, dass** die Kupferionenkonzentration zwischen 45 und 500 mM, vorzugsweise zwischen 100 und 300 mM, liegt.

3. Zusammensetzung nach Anspruch 1 oder 2, **dadurch gekennzeichnet, dass** die vorgenannten Kupferionen Kupfer-(II)-Ionen sind, die vorzugweise aus Kupfersulfat abgeleitet sind.

4. Zusammensetzung nach einem der Ansprüche 1 bis 3, **dadurch gekennzeichnet, dass** der Komplexbildner für das Kupfer aus wenigstens einer Verbindung besteht, die aus Ethylendiamin, Diethylentriamin, Triethylentetramin und Dipropylentriamin ausgewählt ist.

5. Zusammensetzung nach einem der Ansprüche 1 bis 4, **dadurch gekennzeichnet, dass** der vorgenannte Komplexbildner Ethylendiamin ist.

6. Zusammensetzung nach einem der Ansprüche 1 bis 5, **dadurch gekennzeichnet, dass** die Komplexbildnerkonzentration zwischen 45 und 1.500 mM, vorzugsweise zwischen 300 und 900 mM, liegt.

7. Zusammensetzung nach Anspruch 4 oder 5, **dadurch gekennzeichnet, dass** das Molverhältnis des Kupfers zum Komplexbildner zwischen 0,1 und 1, vorzugsweise zwischen 0,2 und 0,4, liegt.

8. Zusammensetzung nach Anspruch 7, **dadurch gekennzeichnet, dass** das Molverhältnis des Kupfers zum Komplexbildner zwischen 0,2 und 0,4 liegt und dass ein Teil des Komplexbildners im Überschuss in einem protonierten Zustand vorliegt.

9. Verfahren zum Füllen einer Aussparung in einem Halbleitersubstrat, insbesondere einer Durchgangsbohrung zur Herstellung von Querverbindungen bei dreidimensionalen integrierten Schaltkreisen, wobei die Aussparung mittels einer Kupferdiffusionsbarrierenschicht bedeckt ist, insbesondere basierend auf Nickel, die wahlweise selbst mit einer Kupferkeimschicht bedeckt ist, **dadurch gekennzeichnet, dass** es Inkontaktbringen der Oberfläche der Aussparung mit einer Galvanisierzusammensetzung nach einem der Ansprüche 1 bis 8 und einen Schritt umfasst, während dem die Oberfläche für eine Zeitspanne unter Spannung gesetzt wird, die lang genug ist, um die Aussparung ausfüllen zu können.

10. Verfahren nach Anspruch 9, **dadurch gekennzeichnet, dass** die vorgenannte Spannung im Gleichstrom-Modus mittels Anlegen eines Stroms pro Einheitsbereich erzeugt wird, der in einem Bereich von 0,2 mA/cm² bis 50 mA/cm², vorzugweise von 0,5 mA/cm² bis 5 mA/cm², liegt.

11. Verfahren nach Anspruch 9 oder 10, **dadurch gekennzeichnet, dass** das Inkontaktbringen der Oberfläche mittels Kälteeintritt durchgeführt wird.

12. Verfahren nach einem der Ansprüche 9 bis 11, **dadurch gekennzeichnet, dass** das Füllen der Aussparung bei einer Temperatur durchgeführt wird, die zwischen 20 und 30 °C liegt.

13. Verfahren nach einem der Ansprüche 9 bis 12, **dadurch gekennzeichnet, dass** das Substrat während des Füllens der Aussparung bei einer Geschwindigkeit, die zwischen 20 und 600 Umdrehungen pro Minute liegt, vorzugsweise bei einer Umdrehungsgeschwindigkeit, die zwischen 100 und 400 Umdrehungen pro Minute liegt, gedreht wird.

14. Verfahren nach einem der Ansprüche 9 bis 13, **dadurch gekennzeichnet, dass** die Oberfläche der zu füllenden Aussparung aus einem eine Barriere für die Diffusion des Kupfers bildenden Material besteht, das wenigstens ein Material umfasst, das aus Tantal (Ta), Titan (Ti), Tantalnitrid (TaN), Titannitrid (TiN), Wolfram (W), Titanwolfram (TiW), und Wolfram-Carbon-Nitrid (WCN) ausgewählt ist.

15. Verfahren nach einem der Ansprüche 9 bis 13, **dadurch gekennzeichnet, dass** die Oberfläche der zu füllenden Aussparung aus einem Material besteht, das eine Nickel-basierte Barriere für die Diffusion des Kupfers bildet.

## Revendications

1. Composition destinée notamment au remplissage, par électrodéposition de cuivre, d'une cavité d'un substrat semi-conducteur telle qu'une structure de type « via traversant » pour la réalisation d'interconnections dans des circuits intégrés en trois dimensions, **caractérisée en ce qu'**elle comprend en solution dans un solvant :
- des ions de cuivre en une concentration comprise entre 45 et 1500 mM ;
- un agent complexant du cuivre constitué d'au moins un composé choisi parmi les polyamines aliphatiques ayant 2 à 4 groupes amino, de préférence l'éthylènediamine, en une concentration comprise entre 45 et 3000 mM ;
- le rapport molaire du cuivre audit agent complexant étant compris entre 0,1 et 5 ;
- de l'acide thiodiglycolique en une concentration comprise entre 1 et 500 mg/l ; et
- éventuellement un système tampon, en particulier du sulfate d'ammonium, en une concentration comprise entre 0,1 et 3 M.

2. Composition selon la revendication 1, **caractérisée en ce que** la concentration des ions du cuivre est comprise entre 45 et 500 mM, de préférence entre 100 et 300 mM.

3. Composition selon la revendication 1 ou 2, **caractérisée en ce que** les ions de cuivre précités sont des ions cuivriques provenant de préférence de sulfate de cuivre.

4. Composition selon l'une des revendications 1 à 3, **caractérisée en ce que** l'agent complexant du cuivre est constitué d'au moins un composé choisi parmi l'éthylènediamine, la diéthylènetriamine, la triéthylènetétramine et la dipropylènetriamine.

5. Composition selon l'une des revendications 1 à 4, **caractérisée en ce que** l'agent complexant précité est l'éthylènediamine.

6. Composition selon l'une des revendications 1 à 5, **caractérisée en ce que** la concentration en agent complexant est comprise entre 45 et 1500 mM, de préférence entre 300 et 900 mM.

7. Composition selon l'une des revendications 4 et 5, **caractérisée en ce que** le rapport molaire du cuivre audit agent complexant est compris entre 0,1 et 1, de préférence entre 0,2 et 0,4.

8. Composition selon la revendication 7, **caractérisée en ce que** le rapport molaire du cuivre à l'agent complexant est compris entre 0,2 et 0,4 et **en ce qu'**une partie de l'agent complexant en excès est à l'état protoné.

9. Procédé de remplissage de la cavité d'un substrat semi-conducteur, en particulier d'un via traversant pour la fabrication d'interconnexions dans des circuits intégrés en trois dimensions, ladite cavité étant recouverte d'une couche barrière de diffusion au cuivre, en particulier à base de nickel, éventuellement elle-même recouverte d'une couche de germination de cuivre, **caractérisé en ce qu'**il comprend la mise en contact de ladite surface de la cavité avec une composition d'électrodéposition selon l'une des revendications 1 à 8, et une étape au cours de laquelle ladite surface est polarisée pendant une durée suffisante pour permettre le remplissage de ladite cavité.

10. Procédé selon la revendication 9, **caractérisé en ce que** la polarisation précitée est réalisée en mode continu en imposant un courant par unité de surface compris dans une gamme de 0,2 mA/cm² à 50 mA/cm², de préférence de 0,5 mA/cm² à 5 mA/cm².

11. Procédé selon la revendication 9 ou 10, **caractérisé en ce que** la mise en contact de ladite surface est réalisée par entrée à froid.

12. Procédé selon l'une des revendications 9 à 11, **caractérisé en ce que** le remplissage de la cavité est réalisée à une température comprise entre 20 et 30°C.

13. Procédé selon l'une des revendications 9 à 12, **caractérisé en ce que**, durant le remplissage de la cavité, le substrat est en rotation à une vitesse comprise entre 20 et 600 tours par minute, de préférence à une vitesse de rotation comprise entre 100 et 400 tours par minute.

14. Procédé selon l'une des revendications 9 à 13, **caractérisé en ce que** la surface de la cavité à remplir est constituée d'un matériau formant barrière de diffusion au cuivre comprenant au moins l'un des matériaux choisis parmi le tantale (Ta), le titane (Ti), le nitrure de tantale (TaN), le nitrure de titane (TiN), le tungstène (W), le titanate de tungstène (TiW) et le nitrure ou carbure de tungstène (WCN).

15. Procédé selon l'une des revendications 9 à 13, **caractérisé en ce que** la surface de la cavité à remplir est constituée d'un matériau formant barrière de diffusion au cuivre à base de nickel.
